# EUROPEAN PATENT SPECIFICATION

(11) **EP 0 800 199 B1**
(45) Date of publication and mention of the grant of the patent: **05.12.2001**
(21) Application number: 97850050.2
(22) Date of filing: 27.03.1997
(51) Int. Cl.: H01J 37/20, H01J 37/28

(54) **Electrode for supporting a sample in a scanning electron microscope**
Elektrode zur Halterung einer Probe in einem Rasterelektronenmikroskop
Electrode pour supporter un échantillon dans un microscope électronique à balayage

(30) Priority: 01.04.1996 SE 9601247
(43) Date of publication of application: 08.10.1997
(73) Proprietor: NYBOM, Rolf, S-161 55 Bromma (SE)
(72) Inventor: NYBOM, Rolf, S-161 55 Bromma (SE)
(74) Representative: Ström, Tore

(56) References cited:
- WO-A-86/02160
- US-A- 4 961 916

## Description

### Background of the Invention

### Field of the invention

The invention relates to an electrode for supporting a sample in a scanning electron microscope, comprising a body having means for mounting the electrode in the microscope, and a flat filter element mounted to said body forming a passageway for sucking air through said filter element and collecting particles entrained into the air, on the surface thereof.

### Description of Related Art

An electrode of this kind is disclosed in WO-A-86/02160 wherein the passageway extends through a hollow stud and connects to a funnel which flares towards the filter element covering the funnel. When sampling, the hollow stud is connected to a suction device to draw fluid through the filter element in order to collect particles such as virus, bacteria, fungus, pollen, and asbestos fibres, that may be entrained into the fluid, on the surface of the filter element. The electrode with the particles collected on the surface of the filter element is coated by evaporation technique with a very thin layer of a material which is electrically conducting as is the electrode. The electrode with the collected sample thus prepared is mounted in a scanning electron microscope for examination and analysis of the sample. The examination and analysis require that the total surface of the filter element is scanned in the microscope because the particles may be irregularly distributed over the total surface of the filter element. Considering the enormous magnification obtained by a scanning electron microscope (10000 to 15000 times) the analysis of the sample is time consuming although the filter element is rather small only about 10 mm in diameter.

### Summary of the Invention

As an essential part of the efforts to eliminate unhealthy conditions in premises where people live or dwell, particularly in hospitals, schools and other public places as well as homes, particularly homes of allergics, samples are taken regularly of the air in such premises and homes in order to detect the presence of mould spores, pollen, bacteria, virus etc., the time consuming examination of these samples placing a heavy economical burden on environmental programs of this type, which is an impeding factor in the performance of such sampling.

The object of the invention is to reduce the time necessary for the examination of the samples and thus to reduce the costs of such examination.

This object is achieved according to the invention by providing an electrode of the kind referred to above with the characterizing features of claim 1.

During sampling the main flow of air through the filter element is concentrated to the opening of the passageway through the electrode body i. e. to an area which is only a fraction of the total area of the filter element. Thus, in order to obtain a reliable result of the examination in a scanning electron microscope following the sampling it is sufficient to scan an area of the filter element which is very small in relation to the total area of the filter element, and accordingly the analysis can be performed in a much shorter time and can be made at lower costs.

Further objects and structural details of the invention will be apparent from the following description of a preferred embodiment of the invention with reference to the accompanying drawing.

### Brief Description of the Drawing

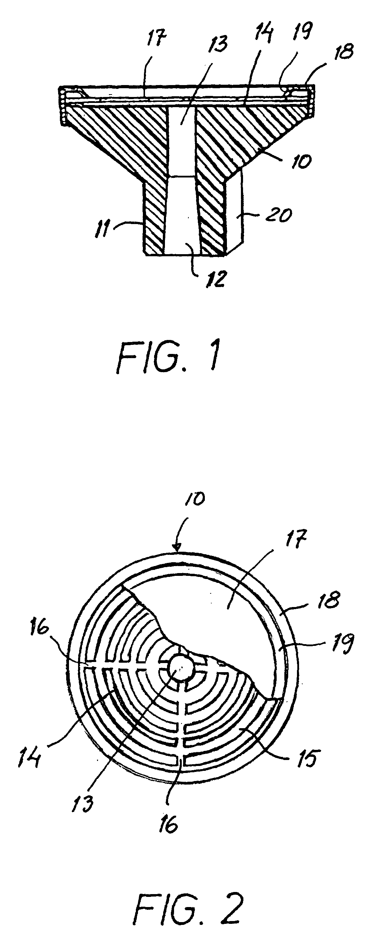

FIG 1 is an axial cross sectional view of an electrode of the invention in the preferred embodiment thereof, and
FIG 2 is a plan view of the electrode the filter element being partly broken away.

### Description of the Preferred Embodiment

The electrode disclosed in the drawing comprises a body 10 of an electrically conducting material, which forms a hollow stud 11. This stud is shaped as the female element of a Luer coupling having a conical passageway 12 to be detachably mounted to a mating pin (not shown) in a scanning electron microscope. An axial cylindrical extension 13 of passageway 12 opens in a circular flat surface 14 formed by body 10. This surface forms concentric circular grooves 15 and four straight radial grooves 16 crossing the circular grooves in communication therewith. Grooves 16 and thus grooves 15 communicate with passageway 13.

A filter element 17 comprising a circular disk is secured to body 10 and is sealed at the periphery thereof between surface 14 on the body and a lock ring 18 attached to the body said lock ring engaging the upper side of the filter element at an annular flange 19.

Stud 11 forms a projecting fin 20 on the outside thereof to be received by a recess in the microscope such that the electrode can be mounted in a single predetermined rotational position only on the pin.

The electrode can be connected at stud 11 to a suction nozzle (not shown) of a suction device, which forms the male part of a Luer coupling and fits in stud 11, for sucking air through filter element 17 at sampling. The air flow through the filter element will be concentrated substantially to a circular area of the filter in register with passageway 13 so that the collection of particles entrained in the air also will be concentrated to this area. As said area is being clogged by particles air can pass to the passageway 13 through filter element 17 and grooves 15 and 16 formed in surface 14 of body 10.

In a practical embodiment of the electrode described the diameter of filter element 17 is about 10 mm and the diameter of passageway 13 is about 1 mm, which means that the collection of particles will be limited to an area having a diameter of 1 to 2 mm. The aperture size of the filter element is of the order of 50 nm in order that such small particles as virus will be trapped on the filter element.

After sampling the filter element and the material collected on the surface thereof is covered by a thin electrically conducting layer of gold/platinum or carbon in a sputter in a manner well known in the art. Then, the electrode is mounted in the electron microscope for examination and analysis of that part of the filter element where the particles, if any, are collected. Since this part has an area which is very small in relation to the total area of the filter element the examination in the electron microscope will not be as time consuming as in case of the total area of the filter element being examined which means that the costs for the examination and analysis will be considerably reduced.

## Claims

1. Electrode for supporting a sample in a scanning electron microscope, comprising a body (10) having means (11) for mounting the electrode in the microscope, and a flat filter element (17) mounted to said body forming a passageway (12, 13) for sucking air through said filter element and collecting particles, if any, entrained into the air, on the surface thereof, **characterized in that** the said passageway (12, 13) opens in a flat surface (14) of the body (10) covered by said filter element (17), the opening of said passageway (12, 13) in said flat surface (14) being limited to a central area of the surface, and that the filter element (17) extends over and around said central area, engaging said flat surface (14).

2. Electrode as in claim 1 wherein said flat surface (14) forms grooves (15, 16) communicating with said passageway (12, 13).

3. Electrode as in claim 2 wherein said grooves comprise concentric circular grooves (15) and straight radial grooves (16) crossing said circular grooves in communication therewith, said grooves communicating with said passageway (12, 13).

## Patentansprüche

1. Elektrode zum Halten einer Probe in einem Raster-Elektronenmikroskop, mit einem Körper (10) mit Mitteln (11) für die Montage der Elektrode im Mikroskop und einem ebenen, an dem besagten Körper angebrachten Filterelement (17), wodurch ein Durchgang (12, 13) zum Ansaugen von Luft durch das besagte Filterelement und zum Sammeln von etwaig in der Luft enthaltenen Teilchen auf dessen Oberfläche gebildet wird, **dadurch gekennzeichnet, dass** der besagte Durchgang (12, 13) sich in einer ebenen Fläche (14) des von dem besagten Filterelement (17) abgedeckten Körpers (10) öffnet, wobei die Öffnung des besagten Durchgangs (12, 13) in der besagten ebenen Fläche (14) auf den mittleren Bereich der Fläche beschränkt ist, und dass das Filterelement (17) sich über den besagten mittleren Bereich und um diesen herum erstreckt und die besagte ebene Fläche (14) fasst.

2. Elektrode nach Anspruch 1, wobei die besagte ebene Fläche (14) mit dem besagten Durchgang (12, 13) in Verbindung stehende Nuten (15, 16) bildet.

3. Elektrode nach Anspruch 2, wobei die besagten Nuten konzentrische, kreisförmige Nuten (15) und die mit ihnen in Verbindung stehenden, kreisförmigen Nuten kreuzende, gerade, radiale Nuten (16) umfassen, wobei diese Nuten mit dem besagten Durchgang (12, 13) in Verbindung stehen.

## Revendications

1. Electrode destinée à supporter un échantillon dans un microscope électronique à balayage, comprenant un corps (10) possédant des moyens (11) utilisés pour monter l'électrode dans le microscope, et un élément filtrant plat (17) monté sur ledit corps formant un passage (12, 13) pour aspirer de fair à travers ledit élément filtrant et recueillir des particules, si elles existent, entraînées dans l'air, sur la surface de ce dernier, **caractérisée en ce que** ledit passage (12, 13) s'ouvre dans une surface plane (14) du corps (10) que ledit élément filtrant (17) recouvre, l'ouverture dudit passage (12, 13) dans ladite surface plane (14) étant limitée à une zone centrale de la surface, et **en ce que** l'élément filtrant (17) s'étend sur et autour de ladite zone centrale, en venant en prise avec ladite surface plane (14).

2. Electrode selon la revendication 1, dans laquelle ladite surface plane (14) forme des rainures (15, 16) qui communiquent avec ledit passage (12, 13).

3. Electrode selon la revendication 2, dans laquelle lesdites rainures comprennent des rainures circulaires concentriques (15) et des rainures radiales droites (16) croisant lesdites rainures circulaires qui sont en communication avec elles, lesdites rainures étant en communication avec ledit passage (12, 13).
